Europäisches Patentamt

European Patent Office

Office européen des brevets

Veröffentlichungsnummer: **0 158 400**

**A2**

# EUROPÄISCHE PATENTANMELDUNG

(21) Anmeldenummer: 85200501.6

(22) Anmeldetag: 01.04.85

(51) Int. Cl.⁴: **H 03 K 17/60**

(30) Priorität: 07.04.84 DE 3413208

(43) Veröffentlichungstag der Anmeldung:
16.10.85 Patentblatt 85/42

(84) Benannte Vertragsstaaten:
DE FR GB

(71) Anmelder: Philips Patentverwaltung GmbH
Billstrasse 80
D-2000 Hamburg 28(DE)

(84) Benannte Vertragsstaaten:
DE

(71) Anmelder: N.V. Philips' Gloeilampenfabrieken
Groenewoudseweg 1
NL-5621 BA Eindhoven(NL)

(84) Benannte Vertragsstaaten:
FR GB

(72) Erfinder: Löhn, Klaus, Dr.
Clara-Viebig-Strasse 13
D-5107 Lammersdorf(DE)

(74) Vertreter: Hartmann, Heinrich, Dipl.-Ing. et al,
Philips Patentverwaltung GmbH Billstrasse 80 Postfach
10 51 49
D-2000 Hamburg 28(DE)

(54) Schaltungsanordnung zum Schalten eines Stromes in einem Transistor.

(57) Es wird eine Schaltungsanordnung zum Schalten eines Stromes in der Emitter-Kollektor-Strecke eines bipolaren Transistors beschrieben, dessen Basisanschluß von einem Schaltsignalgenerator über einen in Reihe geschalteten Zweipol mit induktivem Blindwiderstand ein im wesentlichen rechteckförmiges Schaltsignal zugeführt wird, durch das der Transistor wechselweise in den leitenden oder in den gesperrten Zustand geschaltet wird. Bei einer derartigen Schaltungsanordnung wird auf einfache und kostengünstige Weise eine sehr kurze Fallzeit des Stromes in der Emitter-Kollektor- Strecke des Transistors dadurch erreicht, daß sich der Wert des induktiven Blindwiderstands mit steigendem Strom ($I_B$) durch den Zweipol (L) verringert.

FIG.1

PHILIPS PATENTVERWALTUNG GMBH

Schaltungsanordnung zum Schalten eines Stromes in einem
Transistor

Die Erfindung bezieht sich auf eine Schaltungsanordnung
zum Schalten eines Stromes durch die Emitter-Kollektor-
Strecke eines bipolaren Transistors, dessen Basisanschluß
von einem Schaltsignalgenerator über einen in Reihe geschalteten Zweipol mit induktivem Blindwiderstand ein im
wesentlichen rechteckförmiges Schaltsignal zugeführt wird,
durch das der Transistor wechselweise in den leitenden und
in den gesperrten Zustand geschaltet wird.

Eine derartige Schaltungsanordnung ist aus dem "Handbuch
Schalttransistoren", herausgegeben 1979 von der
Thomson-CSF GmbH, Abschnitt 5.5, Seite 101 ff bekannt. Die
dort beschriebene Schaltungsanordnung umfaßt einen
npn-Schalttransistor, dessen Basisanschluß über eine
Induktivität mit einem ersten Kontakt eines Schalters
verbunden ist. Der erste Kontakt des Schalters ist wahlweise mit einem zweiten oder einem dritten Kontakt verbindbar. Der zweite Kontakt ist mit einer Spannungsquelle
verbunden, die ihm eine gegenüber dem Emitter des Transistors positive Spannung zuführt, während der dritte
Kontakt des Schalters mit einer zweiten Spannungsquelle
verbunden ist, die diesem dritten Kontakt eine gegenüber
dem Emitter des Transistors negative Spannung zuleitet.
Über den Schalter und die Induktivität können die beiden
Spannungen abwechselnd dem Basisanschluß des Transistors
zugeleitet werden.

In der Stellung des Schalters, in der der erste und der
zweite Kontakt miteinander verbunden sind, wird nach dem
Abklingen von Einschwingvorgängen im stationären Zustand
an dem Basisanschluß des Transistors eine positive Spannung angelegt. Es fließt ein positiver Strom in den Basisanschluß des Transistors, der dadurch in einen gesättigten Zustand gesteuert ist. In diesem Zustand wird die Leitfähigkeit des Transistors besonders hoch, d.h. die Spannung zwischen dem Kollektoranschluß und dem Emitteranschluß des Transistors wird besonders klein, so daß die im Transistor auftretende Verlustleistung minimal wird. Der Transistor ist dann in der Lage, große Ströme in seiner Emitter-Kollektor-Strecke bei geringer thermischer Belastung zu führen.

Im gesättigten Zustand, d.h. in dem Zustand extrem hoher Leitfähigkeit, tritt insbesondere im Kollektorgebiet des Transistors eine hohe Konzentration an Minoritätsladungsträgern auf. Diese Minoritätsladungsträger müssen rekombinieren, wenn der Transistor aus dem leitenden in den gesperrten Zustand umgeschaltet wird. Das Rekombinieren der Minoritätsladungsträger erfordert eine bestimmte Zeitdauer, innerhalb deren in der Emitter-Kollektor-Strecke des Transistors noch ein Strom fließt, gleichzeitig jedoch schon eine nennenwerte Kollektor-Emitter-Spannung auftreten kann. Die dadurch entstehende Verlustleistung kann den Transistor thermisch zerstören.

Die Verlustleistung im Transistor beim Umschalten vom leitenden in den gesperrten Zustand läßt sich dadurch verringern, daß ein möglichst hoher Anteil der Minoritätsträger aus der Emitter-Kollektor-Strecke entfernt wird, solange noch ein vom Emitter injizierter Kollektorstrom fließt und damit bevor am Kollektor ein nennenswerter Spannungsabfall auftritt. Die Minoritätsladungsträger werden durch Anlegen einer negativen Spannung an die Basis und damit durch einen negativen Basisstrom abgeführt. Dieser Strom wird zweckmäßig so angepaßt, daß die Emitter-Basisstrecke leitend bleibt, der Emitter also weiterhin injiziert. Besonders zweckmäßig ist ein anfangs

0158400

kleiner und nach Entfernen des überiegenden Teils der Minoritätsladungsträger größerer negativer Basisstrom. Dazu ist bei der bekannten Schaltungsanordnung zwischen dem Schalter und dem Basisanschluß des Transistors die eingangs genannte Induktivität angeordnet, die eine allmähliche Veränderung des Basisstromes zu negativen Werten hin bewirkt. Während dieser allmählichen Stromänderung können die Minoritätsträger rekombinieren. Der Basis-Emitter-Übergang des Transistors bleibt dabei leitend und wird erst gesperrt, wenn der Transistor durch die Rekombination der Minoritätsladungsträger vom gesättigten in den aktiven Zustand übergeht. Die Zeit vom Beginn der Basisstromänderung bis zum Erreichen des aktiven Zustandes wird als Speicherzeit bezeichnet.

Das Absinken des Kollektorstromes erfolgt während des aktiven Zustandes des Transistors innerhalb der sogenannten Fallzeit. Innerhalb dieser Fallzeit tritt praktisch die gesamte Verlustleistung im Transistor auf. Daher ist es erwünscht, zur Verminderung der Verlustleistung und damit der thermischen Belastung des Transistors die Fallzeit soweit wie möglich zu verringern. Am Ende der Speicherzeit befinden sich noch restliche Minoritätsladungsträger im Transistor, die jetzt zweckmäßigerweise durch einen hohen negativen Basisstromimpuls entfernt werden. Dies verringert die Fallzeit wesentlich, die andernfalls durch eine Rekombination der restlichen Minoritätsladungsträger durch den Kollektorstrom bestimmt wird.

Aus dem eingangs genannten "Handbuch Schalttransistoren", beispielsweise Bild 17a auf Seite 106 oder Bild 24 auf Seite 130, sind Schaltungsanordnungen zur Verringerung der Fallzeit durch Anwendung eines hohen negativen Stromimpulses am Ende der Speicherzeit bekannt. Die dort beschriebenen Schaltungsanordnungen sind jedoch sehr aufwendig und kostspielig und haben darüber hinaus einen hohen Platzbedarf.

Die Erfindung hat die Aufgabe, eine einfache, kostengünstige und platzsparende Schaltungsanordnung zum Schalten eines Stromes in der Emitter-Kollektor-Strecke eines bipolaren Transistors mit minimaler Fallzeit für den Strom zu schaffen.

Die Aufgabe wird nach der Erfindung dadurch gelöst, daß der Zweipol derart ausgestaltet ist, daß sich bei einer Schaltungsanordnung der eingangs genanntenArt der Wert des induktiven Blindwiderstands mit steigendem Strom durch den Zweipol verringert.

Der erfindungsgemäß ausgebildete Zweipol weist bei geringen Strömen einen höheren induktiven Blindwiderstand auf als bei hohen Strömen, zeigt also ein nichtlineares Verhalten mit progressivem Stromverlauf. Einem geringen Strom durch den Zweipol stellt sich zunächst ein hoher induktiver Blindwiderstand entgegen, so daß die zeitliche Änderung des Stromes nur gering ist. Mit zunehmendem Strom sinkt der induktive Blindwiderstand und die Änderungen des Stromes über der Zeit werden größer. In der erfindungsgemäßen Schaltungsanordnung fließt der Basisstrom des Transistors über einen derartigen Zweipol. Befindet sich der Transistor im leitenden Zustand, fließt ein zunächst verhältnismäßig geringer Basisstrom. Ändert das dem Basisanschluß zugeführte Schaltsignal seinen Wert, folgt der Basisstrom dieser Änderung aufgrund des hohen induktiven Blindwiderstands des Zweipols zunächst nur langsam. Erst wenn nach Ablauf einer bestimmten Zeitdauer der Basisstrom um einen bestimmten Betrag angestiegen ist, verringert sich der induktive Blindwiderstand, und es erfolgt ein rascher Anstieg des Basisstromes.

Die Schaltungsanordnung wird nun vorzugsweise derart dimensioniert, daß die Zeitdauer, während der der Strom durch den Zweipol im wesentlichen gering ist und sich geringfügig ändert, mit der Speicherzeit des Transistors übereinstimmt, d.h. mit der Zeitdauer, während der der Abbau der Minoritätsladungsträger durch den angelegten Basisstrom erfolgt. Der nach dieser Zeit erfolgende steile Anstieg des Basisstromes fällt dann genau mit dem Eintreten des Transistors in den aktiven Zustand zusammen.Der Transistor wird dann sehr schnell in den gesperrten Zustand überführt, d.h. der Kollektorstrom des Transistors weist eine sehr kurze Fallzeit auf.

Nach einer vorteilhaften Weiterbildung der Erfindung besteht der Zweipol aus einer Spule mit einem ferro- bzw. ferrimagnetischen Kern, der durch den im Basisanschluß des Transistors fließenden Strom bis in die Sättigung magnetisiert wird. Vorzugsweise wird die Spule mit einigen Leiterwindungen auf einem geschlossenen Ferrit-Ringkern ausgeführt. Durch Wahl der Abmessungen des Ringkernes, seiner magnetischen Eigenschaften sowie der Anzahl der Windungen kann eine derartig ausgeführte Spule leicht an die Dimensionierung der übrigen Schaltungsanordnung angepaßt werden. Die beschriebene Spule ist darüber hinaus einfach und kostengünstig herstellbar und weist eine kompakte Bauform auf.

Ein Ausführungsbeispiel der Erfindung ist in der Zeichnung dargestellt und wird im folgenden näher beschrieben. Es zeigen

Fig. 1 ein Prinzipschaltbild einer erfindungsgemäßen Schaltungsanordnung,

Fig. 2 die zeitlichen Verläufe einiger Signale aus Fig. 1.

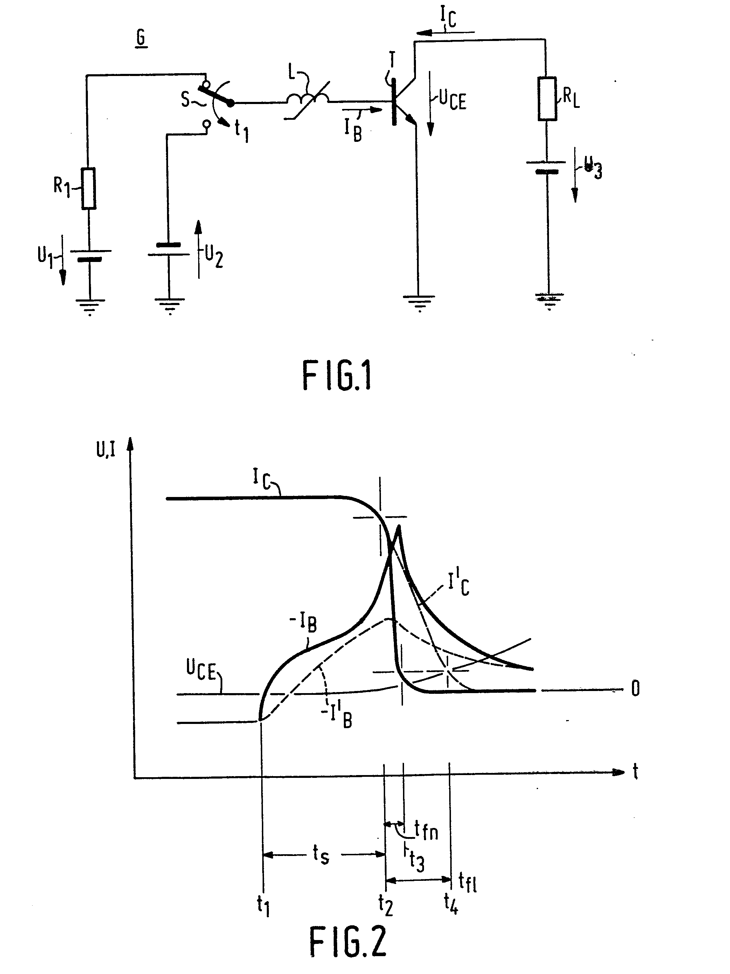

In Fig. 1 ist mit G das Ersatzschaltbild eines Schaltsignalgenerators bezeichnet. Dieses umfaßt zwei Gleichspannungsquellen, die die in Pfeilrichtung positiven Spannungen $U_1$ und $U_2$ abgeben. Der Widerstand $R_1$ stellt den Innenwiderstand der Gleichspannungsquelle $U_1$ dar. Über einen Schalter S werden die Gleichspannungen $U_1$ und $U_2$ wahlweise einem ersten Anschluß eines Zweipols L mit induktivem Blindwiderstand zugeführt, dessen zweiter Anschluß mit dem Basisanschluß eines Transistors T vom npn-Leitungstyp verbunden ist. Durch den Zweipol fließt der Basisstrom $I_b$ des Transistors T mit positiver Stromrichtung zum Basisanschluß des Transistors T hin. Die dem Widerstand $R_1$ bzw. dem Schalter S abgewandten Anschlüsse der Gleichspannungsquellen $U_1$ und $U_2$ sind an Masse gelegt.

Der Transistor T ist mit seinem Emitteranschluß ebenfalls an Masse gelegt und mit seinem Kollektoranschluß über einen Lastwiderstand $R_L$ an den positiven Pol einer dritten Gleichspannungsquelle angeschlossen, die eine Gleichspannung $U_3$ abgibt und mit ihrem negativen Pol an Masse gelegt ist. Die dritte Gleichspannungsquelle $U_3$ treibt einen Strom $I_C$ mit der durch den Pfeil gekennzeichneten positiven Flußrichtung durch den Lastwiderstand $R_L$ und die Emitter-Kollektor-Strecke des Transistors T. Die Größe des Stromes $I_C$ wird durch den in den Basisanschluß des Transistors T hineinfließenden Strom $I_B$ gesteuert. Der Schalter S befindet sich dabei in der gezeichneten Stellung, d.h. der Basisanschluß des Transistors T ist über den Zweipol L und den Widerstand $R_1$ mit der positiven Spannung $U_1$ verbunden.

In Fig. 2 sind die zeitlichen Verläufe der Ströme $I_B$ und $I_C$ sowie der zeitliche Verlauf der Spannung $U_{CE}$ über der Emitter-Kollektor-Strecke des Transistors T über der Zeit aufgetragen. Nach Abklingen der beim Umschalten des Schalters S auftretenden Einschwingvorgänge stellt sich ein stationärer Zustand ein, in dem die Ströme $I_B$ und $I_C$ sowie die Spannung $U_{CE}$ konstant sind.

Zum Zeitpunkt $t_1$ wird der Schalter S umgeschaltet und dadurch der Basisanschluß des Transistors T über den Zweipol L mit der Gleichspannungsquelle $U_2$ verbunden. Der Transistor T befindet sich zum Zeitpunkt $t_1$ im gesättigten Zustand. Am Zweipol L liegt nun eine Spannung mit umgekehrter Polarität, durch die der Strom $I_B$ umgepolt wird. Aufgrund des induktiven Blindwiderstands des Zweipols L ändert sich der Wert des Stromes $I_B$ allmählich von positiven zu negativen Werten. In dem gezeigten Beispiel weist der Zweipol L, beispielsweise eine Spule mit einem Ferrit-Ringkern, eine Hysterese-Kennlinie auf. Auch bei Aussteuerung über nur einen Teil der gesamten Hysterese-Kennlinie ergibt sich eine als Unterschleife bezeichnete neue Hysterese-Kennlinie. Im gezeigten Beispiel wird nur eine Unterschleife der Kennlinie des Zweipols im Bereich zwischen dem positiven Basisstrom im gesättigten Zustand des Transistors T und im Vergleich dazu größeren negativen Stromwerten ausgesteuert. Daher nimmt beim Umpolen der Strom $I_B$ unmittelbar nach dem Zeitpunkt $t_1$ schnell auf kleine Werte ab. Im Bereich kleiner Stromstärken erfolgt nur eine langsame Änderung des Stromes $I_B$, bis mit Erreichen hinreichend großer negativer Werte wieder eine rasche Änderung des Stromes $I_B$ einsetzt.

Die Elemente der Schaltungsanordnung, insbesondere der Widerstand $R_2$ und der induktive Blindwiderstand des Zweipols L, sind derart gewählt, daß die zweite rasche zeitliche Änderung des Stromes $I_B$ im Bereich eines Zeitpunktes $t_2$ erfolgt, der in einem zeitlichen Abstand $t_s$ auf den Zeitpunkt $t_1$ folgt. Dabei ist $t_s$ die Speicherzeit des Transistors T, d.h. die Zeit, in der die Minoritätsladungsträgerdichte im Transistor T soweit vermindert wird, daß der Transistor T aus dem gesättigten in den aktiven Zustand überführt wird.

Mit dem nun folgenden raschen Anstieg des Stromes $I_B$ wird der Transistor T in sehr kurzer Zeit durch den aktiven in den gesperrten Zustand gesteuert. Dies geschieht im Zeitraum zwischen den Zeitpunkten $t_2$ und $t_3$, der als Fallzeit $t_{fn}$ bezeichnet wird. In der Fallzeit $t_{fn}$ nimmt der Kollektorstrom $I_C$ des Transistors T von 90% auf 10% seines Wertes zum Zeitpunkt $t_1$ ab. Mit dem Abfall des Kollektorstromes $I_C$ sinkt dann der Strom $I_B$ ebenfalls auf Null ab. Gleichzeitig steigt die Spannung $U_{CE}$ über der Emitter-Kollektor-Strecke des Transistors T auf den Endwert $U_3$ an. Dieser Anstieg erfolgt in den in Fig. 2 dargestellten Signalverläufen verhältnismäßig flach, hervorgerufen durch einen Schutzkondensator parallel zur Emitter-Kollektor-Strecke des Transistors T, der in Fig. 1 nicht dargestellt ist.

In Fig. 2 ist ferner mit gestrichelten Linien zum Vergleich der Fall dargestellt, daß als Zweipol L eine Spule mit konstantem, d.h. stromunabhängigem Blindwiderstand eingesetzt wird. Es ergibt sich dann eine nahezu lineare zeitliche Änderung des Stromes $I_B$, dargestellt durch die Kurve $I'_B$. Der Strom $I'_B$ verändert sich gleichförmig, bis der Transistor T in den aktiven Zustand gerät, und sinkt dann auf Null ab. Der Transistor T wird wesentlich langsamer in den gesperrten Zustand überführt, der Kollektorstrom weist den durch $I'_C$ gekennzeichneten, gestrichelten zeitlichen Verlauf auf. Er erreicht erst zum Zeitpunkt $t_4$ 10% seines Wertes zum Zeitpunkt $t_1$. Die Fallzeit $t_{fl}$, das Zeitintervall zwischen den Zeitpunkten $t_2$ und $t_4$, ist wesentlich größer als $t_{fn}$.

PATENTANSPRÜCHE

1.    Schaltungsanordnung zum Schalten eines Stromes durch die Emitter-Kollektor-Strecke eines bipolaren Transistors, dessen Basisanschluß von einem Schaltsignalgenerator über einen in Reihe geschalteten Zweipol mit induktivem Blindwiderstand ein im wesentlichen rechteckförmiges Schaltsignal zugeführt wird, durch das der Transistor wechselweise in den leitenden und in den gesperrten Zustand geschaltet wird, dadurch gekennzeichnet, daß der Zweipol (L) derart ausgestaltet ist, daß sich der Wert des induktiven Blindwiderstands mit steigendem Strom ($I_B$) durch den Zweipol (L) verringert.

2.    Schaltungsanordnung nach Anspruch 1, dadurch gekennzeichnet, daß der Zweipol (L) aus einer Spule mit einem ferro- bzw. ferrimagnetischen Kern besteht, der durch den im Basisanschluß des Transistors (T) fließenden Strom ($I_B$) bis in die Sättigung magnetisiert wird.

FIG.1

FIG.2